(19) Europäisches Patentamt
European Patent Office
Office européen des brevets

(11) Publication number: **0 444 213 A1**

# (12) EUROPEAN PATENT APPLICATION published in accordance with Art. 158(3) EPC

(21) Application number: **90913873.7**

(22) Date of filing: **20.09.90**

(86) International application number: **PCT/JP90/01206**

(87) International publication number: **WO 91/04284 (04.04.91 91/08)**

(51) Int. Cl.$^5$: **C08F 136/16**, C08F 299/00, C08J 5/24

(30) Priority: **20.09.89 JP 242034/89**

(43) Date of publication of application: **04.09.91 Bulletin 91/36**

(84) Designated Contracting States: **DE FR GB**

(71) Applicant: **HITACHI, LTD.**
**6, Kanda Surugadai 4-chome**
**Chiyoda-ku, Tokyo 101(JP)**

(72) Inventor: **NISHIMURA, Shin**
**20-3, Ayukawacho 6-chome**
**Hitachi-shi Ibaraki 316(JP)**
Inventor: **NAGAI, Akira**
**20-1, Mizukicho 2-chome**
**Hitachi-shi Ibaraki 316(JP)**
Inventor: **TAKAHASHI, Akio**
**3595, Kanaicho**
**Hitachiota-shi Ibaraki 313(JP)**
Inventor: **MUKOO, Akio**
**498-21, Kasaharacho**
**Mito-shi Ibaraki 310(JP)**

(74) Representative: **Patentanwälte Beetz sen. - Beetz jun. Timpe - Siegfried - Schmitt-Fumian- Mayr**
**Steinsdorfstrasse 10**
**W-8000 München 22(DE)**

## (54) HEXAFLUOROBUTADIENE PREPOLYMER, PRODUCTION THEREOF, POLYMERIZABLE COMPOSITION, AND LAMINATE.

(57) New hexafluorobutadiene prepolymers of the following formula and hardenable material prepared therefrom: $R-(CF_2-CF=CF-CF_2)_n-H$, wherein R represents fluorine or a residue of an anionic polymerization initiator, and n is 4 to 6,000. A material for printed circuit boards excellent in heat and moisture resistance and electric properties.

EP 0 444 213 A1

FIG. 1

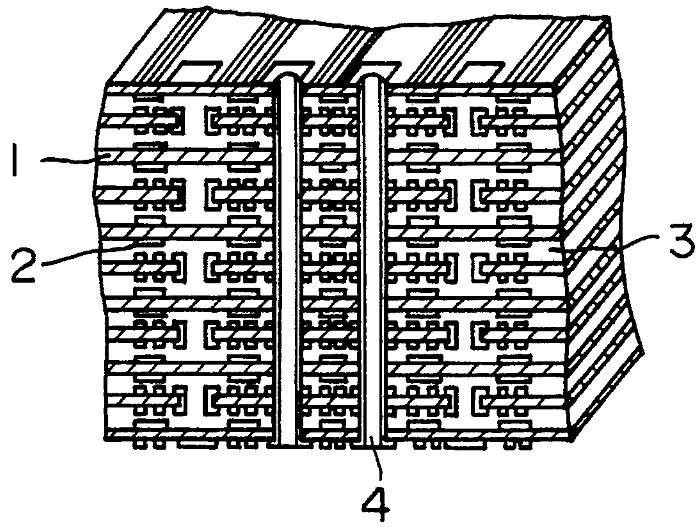

## BACKGROUND OF THE INVENTION

### Field of the Invention

The present invention relates to novel hexafluorobutadiene prepolymer, curable materials using the same and laminates comprising the curable materials and more particularly, to materials for print circuit substrates having excellent heat resistance, moisture resistance and electric properties.

### Statement of the Prior Art

For polymerization of 1,3-hexafluorobutadiene, radical polymerization and anion polymerization have been investigated. In the former radical polymerization, polymerizable composition occurs at random so that the polymerization product is a mixture of 1,2-polymer and 1,4-polymer (U.S. Patent No. 3,663,521). The latter anion polymerization has been considered as an effective means for obtaining polymer having excellent steric regularity; however, it has been pointed out that when an alkyl lithium, Grignard reagent, an alkoxide or the like is used as a reaction initiator, the yield of polymer is as extremely poor as less than 1% (Journal of Polymer Science, Part B, 6, 639-642, 1968).

For this reason, it is the actual situation that in spite of realizing a low water absorption and a low moisture vapor permeability thereby to expect improvement in moisture resistance, decrease in a dielectric constant, improvement in the surface quality, imparting heat resistance, etc., hexafluoro-1,3-butadiene polymer has not been applied to curable materials which are obtained by impregnating fibrous substrates including a glass prepreg, a glass mat, etc. with the polymer.

On the other hand, severe requirements for laminate materials used in multilayer circuit substrates for electron devices have been made to reduce their dielectric constant, from viewpoints of improving reliability on moistureproof and reliability on heat resistance and increasing computation speed of computers. As a means therefor, it has been investigated to apply fluorine materials (Japanese Patent Application Laid-Open No. 62-29454). The main trend of investigations on fluorine materials is toward thermoplastic saturated fluorocarbon materials but it has not been reported to apply thermosetting fluorine materials.

Thermoplastic saturated fluorine materials encounter many problems that material fluidity in laminate processing is poor, a thermal expansion coefficient is large due to a low glass transition point of molded products, dimensional stability in molded laminate products which is the key in achieving a minute circuit is inferior, wettability to fibrous substrates such as glass, Kevlar, etc. is poor to worsen impregnation property, it is difficult to improve mechanical strength, etc. It is thus difficult to apply thermoplastic fluorine materials to laminate materials.

## SUMMARY OF THE INVENTION

An object of the present invention is to provide novel hexafluoro-1,3-butadiene prepolymers obtained by the anion polymerization.

That is, the hexafluoro-1,3-butadiene prepolymer obtained in the present invention is represented by general formula:

$$R \leftarrow\!\!\!\!\!-\; CF_2 - CF = CF - CF_2 \;\!-\!\!\!\!\rightarrow_n H$$

wherein R is fluorine or a residue of anionic polymerization initiator; and n is 4 to 6000, preferably 10 to 1000. In terms of its molecular weight, the hexafluorobutadiene prepolymer is a thermosetting oligomer having a molecular weight in a range of about 700 to about 1,000,000. The prepolymer is excellent in fluidity of material in molding processing since the prepolymer is a thermosetting material with low viscosity.

The fluorine laminates provided by the present invention are characteristic of properties such as heat resistance, moisture resistance, a low dielectric constant, etc. and are applicable to high density multilayer substrates for computers. The fluorine laminates are extremely useful for achieving high efficiency and high speed computation of computers.

Based on the finding on a new process for anion polymerization of hexafluorobutadiene, the object of the present invention has been achieved using thermosetting polymer of hexafluorobutadiene which is a base for curable materials. The object of the present invention has been achieved further by providing

compositions comprising the prepolymer, curable materials obtained by impregnating with the composition and drying, and laminates comprising the curable materials.

The present invention is thus directed to:

1. A hexafluorobutadiene prepolymer represented by general formula:

$$R \leftarrow\!\!\!-\; CF_2 - CF = CF - CF_2 \xrightarrow{}_{n} H$$

wherein R is fluorine or a residue of anionic polymerization initiator; and n is 4 to 6000, preferably 10 to 1000.

2. A curable composition comprising the prepolymer and a polymerizable compound.

3. A curable material comprising the prepolymer or the composition having impregnated therewith a fibrous substrate.

BRIEF DESCRIPTION OF THE DRAWINGS

Fig. 1 is a perspective view of the cross section of a multilayer printing plate which is an embodiment of the present invention.

Fig. 2 is a sketchy drawing of a device for anionic polymerization or hexafluorobutadiene. Pyrex glass-made vacuum line is so connected that dry nitrogen gas 5 and hexafluorobutadiene gas 7 are introduced therein. An ampoule tube 12 is connected with the vacuum line.

Fig. 3 shows infrared absorption spectrum of the polymerization product of hexafluorobutadiene.

| | |
|---|---|
| 1 | substrate |
| 2 | circuit |
| 3 | prepreg sheet |
| 4 | through hole |
| 5 | dry nitrogen gas |
| 6 | vacuum pump |
| 7 | hexafluorobutadiene gas |
| 8 | pressure tube |
| 9 | pinch cock |
| 10 | silicone tube |
| 11 | heat seal |
| 12 | ampoule tube |
| (a) | Example 1 |
| (b) | Example 17 |

DESCRIPTION OF THE PREFERRED EMBODIMENTS

In the present invention, hexafluoro-1,3-butadiene prepolymer is a polymer represented by general formula:

$$R \leftarrow\!\!\!-\; CF_2 - CF = CF - CF_2 \xrightarrow{}_{n} H$$

(since n is not greater than 4, the prepolymer has at least 4 unsaturated bonds in one molecule; when crosslinked, the cured product having an excellent heat resistance is obtained) which is obtained by anionic polymerization of hexafluoro-1,3-butadiene, and is a powder at room temperature. In addition, the prepolymer is an oligomer having a number average molecular weight of the polymer is about 700 to about 1,000,000.

In terms of viscosity, the prepolymer is as follows.

In order to determine a molecular weight of the hexafluorobutadiene prepolymer according to the present invention, dynamic viscosity (centistokes) of the prepolymer polymerized under conditions described below was measured. The results are shown in Table 1. In Run Nos. 1 to 6, the resulting prepolymer was dissolved in a hexafluorobenzene solution and its dynamic viscosity (constant of viscometer

x flow time) was determined, wherein the constant of viscometer was 0.006. The viscometer used is a Canon Mining type viscometer manufactured by Shibata Scientific Equipment Industry Co., Ltd. Polymerization in Run Nos. 1 to 3 was performed as in Example 2. Polymerization in Run Nos. 4 to 6 was performed as in Example 1.

t-BuOCs/THF and TOL are abbreviations for t-butoxy cesium/tetrahydrofuran and toluene, respectively. Hexafluorobutadiene : t-BuOCs (weight ratio) is 50 : 1.

Table 1

| No. | Condition for polymerization (initiator/ solvent) | Concentration of prepolymer (g/dl) | Flow time (sec) | Dynamic viscosity (cst) |
|---|---|---|---|---|
| 1 | t-BuOCs/THF | 1.112 | 216.05 | 1.296 |
| 2 | " | 0.741 | 212.04 | 1.272 |
| 3 | " | 0.370 | 209.38 | 1.256 |
| 4 | t-BuOCs/TOL | 1.028 | 226.94 | 1.362 |
| 5 | " | 0.686 | 219.26 | 1.316 |
| 6 | " | 0.343 | 214.15 | 1.285 |

In polymerization using t-BuOCs/THF, the prepolymer of the present invention showed dynamic viscosity of 1.296 to 1.256 centistokes in the prepolymer concentration (g/dl) of 1.112 to 0.370. In polymerization using t-BuOCs/TOL, the prepolymer of the present invention showed dynamic viscosity of 1.362 to 1.285 centistokes in the prepolymer concentration (g/dl) of 1.028 to 0.343.

From the foregoing results, the prepolymer of the present invention has a molecular weight showing 1.25 to 1.50 centistokes in terms of dynamic viscosity, when the prepolymer is dissolved in hexafluorobenzene to form a solution in a concentration of 1 g/dl.

This value is $10^4$ order to 105 order in terms of molecular weight.

The mechanism of 1,4 polymerization of hexafluorobutadiene which is a conjugated diene compound is considered as follows.

$$R^{\ominus} + CF_2 = CF\text{-}CF\text{-}CF_2 \longrightarrow R\text{-}CF_2\text{-}\overset{\ominus}{C}F\text{-}CF{=}CF_2$$

initiator

$$\downarrow$$

$$R\text{-}CF_2\text{-}CF^{\ominus}\text{-}CF{=}CF_2$$

$$\downarrow$$

$$R\text{-}CF_2\text{-}CF{=}CF\text{-}CF_2^{\ominus}$$

In butadiene, $\pi$ electron conjugation system is present in the whole molecule so that in addition to 1,2 polymerization through ordinary vinyl polymerization, an anion which is the extension terminal moves toward the terminal as shown in the above equation, during which polymerization proceeds. It is considered that also in hexafluorobutadiene, 1,4 polymerization would proceed by similar mechanism.

Accordingly, the anionic residue of the initiator binds at the terminal. Because of termination with HCl, the terminal at the opposite side is bound to $H^+$.

$$R\text{-}(CF_2 - CF = CF - CF_2)_n\text{-} H$$

(R: anionic residue of an initiator)

In the case of using, for example, CsF, where R is F and t-butoxy cesium is used:

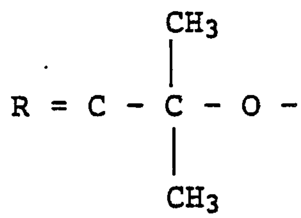

or the like corresponds to R.

The hexafluorobutadiene prepolymer can be obtained in a high yield by polymerization of hexafluoro-1,3-butadiene in the presence of a compound containing cesium or a compound having an ionic radius in cation of at least 1.6 angstrom.

With respect to hexafluorobutadiene monomer, the resulting prepolymer and polytetrafluoroethylene, structures of the compounds and chemical shifts were examined by measurement of NMR. As the result, absorptions based on $-CF_2-CF=-CF_2-CF_2-$ were recognized in the prepolymer of the present invention, as shown in Fig. 4. The results of NMR measurement are summarized in Table 2.

Table 2. Relationship between chemical structure and chemical shift

| Structure | $\delta \times 10^6$ | Monomer HFBD | Polymer PHFBD | Comparison PTFE |
|---|---|---|---|---|
| $*CF_2=CF-$ | 155 | ○ | | |
| $=*CF-CF_2-$ | 125-130 | ○ | ○ | |
| $-*CF_2-CF=$ | 120 | | ○ | |
| $-*CF_2-CF_2-$ | 112 | | | ○ |

As compounds containing cesium, there are cesium fluoride, cesium bromide, cesium chloride, cesium iodide, etc. As alkyl cesiums, there are n-butyl cesium, sec-butyl cesium, tert-butyl cesium, n-propyl cesium, iso-propyl cesium, ethyl cesium, methyl cesium, etc. As cesium alcoholates, there are cesium alkyl alcoholates such as n-butoxy cesium, sec-butoxy cesium, tert-butoxy cesium, n-propoxy cesium, iso-propoxy cesium, ethoxy cesium, mecnoxy cesium, n-butyl-di-iso-propoxy cesium, di-iso-propyl-iso-propoxy cesium, monoacetyl acetonate-iso-propoxy cesium, etc.; and cesium chelate alcoholates, etc.

As cesium salts, there are cesium carbonate, cesium bicarbonate, cesium acetate, cesium sulfate, cesium nitrate, etc.

In addition, there are complexes with the cesium compounds described above, for example, amine complexes such as diisopropylamine-n-butyl cesium, diethylamine/n-butyl cesium, etc.; acetyl acetonate/n-butyl cesium, ethyl cyanoaceate/n-butyl cesium, etc.

The cesium-containing compounds described above which can be used in the present invention may be used alone or in combination. A concentration of the initiator is chosen from a range of 0.01 to 10 mol% based on hexafluorobutadiene monomer.

In the present invention, examples of the compound having an ionic radius in cation of at least 1.6

angstrom include metal atoms such as cesium, rubidium, etc.; tertiary amines such as triphenylamine, tri(t-butyl)amine, etc. Among them, cesium ions are particularly preferred as the cation.

As media used in the anion polymerization described above, there are solvents of aromatic hydrocarbon type such as benzene, toluene, xylene, etc.; solvents of hydrocarbon type such as hexane, cycrohexamine, etc.; solvents of fluorine-containing type such as hexafluorobenzene, etc.; solvents of acetic acid esters such as ethyl acetate, methyl acetate, etc.; solvents of ether type such as diethyl ether, 1,2-dimethoxyethane, tetrahydrofuran, etc. Among them, benzene, toluene and tetrahydrofuran are particularly preferred.

Where the solvent is used, it is necessary that the solvent be thoroughly purified to remove any substance such as oxygen or water dissolved which can be a terminator of the anionic polymerization.

Conditions for the polymerization are chosen from a temperature range higher than room temperature, preferably from a range of 40 to 80 °C and from several days, preferably about 7 days.

In the present invention, the fibrous substrate refers to woven cloth and non-woven cloth using known inorganic and organic fibers such as glass fiber, titanium fiber, aromatic polyamide fiber, polyester fiber, polyamideimide fiber, polyimide fiber, etc. The curable material of the present invention can be provided by the steps of impregnating the hexafluorobutadiene prepolymer obtained by the polymerization described above with the fibrous substrate in the solvent system or the non-solvent system and then drying the same.

As the hexafluorobutadiene prepolymer used in preparing the curable material described above, it is preferred to use an oligomer having a number average molecular weight of 700 to about 1,000,000, especially several thousands to several tens thousands, from a viewpoint of fluidity upon adhesion of a tacky laminate of the prepreg. When the polymer having an excessively large molecular weight is used, compatibility and reactivity with other polymers may be reduced in some occasion.

In the present invention, the polymerizable compounds are exemplified with compounds containing a reactive double bond(s) such as ethylene, vinyl chloride, vinylidene fluoride, acrylic acid, methacrylic acid, methyl methacrylate, butyl acrylate, styrene, fluorostyrene, $\alpha$-methylstyrene, allylbenzene, allylphenol, butadiene, isobutylene, isoprene, N-phenylmaleimide, N,N'-substituted unsaturated imides, vinylphenols, vinyl ethers, etc., and fluorinated compounds thereof. A ratio of the polymerizable compound formulated is appropriately chosen depending upon purpose of its use and utility. The polymer which is used in the present invention by mixing with the prepolymer refers to known thermosetting polymer and thermoplastic resin. Specific examples of the polymer include epoxy resin, phenol resin, unsaturated polyester resin, melamine resin, urea resin, diallyl phthalate resin, urethane resin, addition reactive polyimide resin, acrylate resin, methacrylate resin, styrene resin, p-hydroxystyrene resin, tirazine resin, perfluoroethylene resin, polybutene resin, etc.

Among them, particularly preferred are polybutadiene, phenol resin, addition reactive polyimide resin, p-hydroxystyrene resin and tirazine resin, in view of heat resistance and molding processing which are well balanced.

In addition, there may also be used cured polymer obtained by three-dimensionally crosslinking hexafluorobutadiane polymer by the assistance of heat or/and optical energy.

The composition comprising the aforesaid polymer and hexafluorobutadiene polymer is impregnated with the fibrous substrate in the solvent system or in the non-solvent system and then dried to give the curable material.

Next, a general process for preparing the laminate in the present invention is explained below.

Firstly, the hexafluorobutadiene prepolymer or the composition containing the prepolymer is dissolved in an organic solvent to prepare varnish. Examples of the organic solvent include toluene, xylene, acetone, methyl ethyl ketone, N,N-dimethylformamide, N-methylpyrrolidone, dimethylsulfoxide, trichloroethylene, trichloroethane, methylene chloride, dioxan, ethyl acetate, etc. Any solvent may be used so long as it can uniformly dissolve the composition described above. A radical polymerization initiator and various additives are added to the thus prepared varnish to prepare a varnish for impregnation.

Typical examples of the radical polymerization initiator include benzoyl peroxide, dicumyl peroxide, methyl ethyl ketone peroxide, t-butyl peroxylauate, di-t-butyl peroxyphthalate, dibenzyloxide, 2,5-dimethyl-2,5-di(t-butylperoxy)hexane,t-butylcumyl peroxide, t-butyl hydroperoxide, di-t-butyl peroxide, 2,5-dimethyl-2,5-di(t-butylperoxy)hexane (3), diisopropylbenzene hydroperoxide, p-menthane hydroperoxide, pinane hydroperoxide, 2,5-dimethyl-hexane-2,5-dihydroperoxide, cumene hydroperoxide, etc. These initiators are added in an amount of 0.1 to 10 parts by weight based on 100 parts by weight of the composition. Next, the varnish for impregnation is impregnated with a sheet-like substrate, which is then dried at room temperature to 170 °C to give tackiness-free prepreg. In this case, a temperature for drying is determined depending upon solvent and initiator used. Finally, necessary sheets of the resulting prepreg are laminated with each other and thermal curing reaction is performed at 100 to 250 °C under a pressure of 1 to 100 kgf/cm$^2$ to obtain the laminate.

As the sheet-like substrate, there may be used almost all materials conventionally used in laminate materials. As inorganic fibers, there are a variety of glasses such as E glass, C glass, A glass, S glass, D glass and YM-31-A glass which contain $SiO_2$, $Al_2O_3$, etc. as components, and Q glass using quartz, etc. As organic fibers, there are aramid fibers containing as the component a high molecular compound having an aromatic polyamideimide skeleton, etc.

A copper-lined laminate may also be obtained by laminating necessary sheets of the prepreg described above, providing a copper foil on at least one surface and performing thermal curing reaction at 100 to 250 °C under a pressure of 1 to 100 kgf/cm$^2$.

Furthermore, a multilayer printing circuit plate (Fig. 1) may be obtained by heating a laminate substrate having a conductive pattern on at least one surface at 100 to 250 °C under a pressure of 1 to 100 kgf/cm$^2$ via the prepreg described above to effect curing of the prepreg.

As the various additives which are added to the varnish for impregnation, there are a plasticizing agent, a flame retardant, a treating agent, various inorganic and organic powders such as silica powders, etc.

The hexafluorobutadiene prepolymer in the present invention is an oligomer having double bonds on the backbone and having a number average molecular weight of about 700 to about 1,000,000. For this reason, the polymer is characterized in that a range of fluidizing temperature is low at a softening point of 100 °C or lower, as compared to conventional fluorine polymer. In addition, the double bonds on the backbone cause self polymerization between molecules or crosslink with other polymerizable components to form the three-dimensionally crosslinked product having heat resistance, moisture resistance and a low dielectric constant.

Thus, the polymer enables to impregnation with prepreg, mat, chop, etc., which was achieved by conventional thermoplastic tetrafluoroethylene polymer only with difficulty, and provides a novel fluorine curable material.

Furthermore, in the curable material of the present invention, a margin of material fluidity in molding processing such as adhesion of the laminate, etc. can be greatly improved to contribute to improving dimensional stability of the laminate such as a multilayer circuit plate, etc. In addition, thelaminate having heat resistance, moisture resistance and a low dielectric constant can be provided.

Example 1

Synthesis of hexafluorobutadiene prepolymer:

While reducing pressure, cesium fluoride (manufactured by Wako Pure Chemical Industry Co., Ltd.) charged in a Pyrex pressure container was heated at 120 to 160 °C on an oil bath followed by drying for 2 hours. Then, 0.12 g (0.79 mmol) of cesium fluoride was charged in an ampoule tube of a 100 ml volume in a glove box, which had been replaced with nitrogen at least 3 times, and connected with a vacuum line as shown in Fig. 2, using a T-shaped tube and a silicone tube.

After the pressure in the vacuum line was reduced, hexafluoro-1,3-butadiene gas purified by molecular sieve and calcium sulfate was introduced into the vacuum line. Hexafluoro-1,3-butadiene which was cooled and liquefied with dry ice and methanol was collected.

Liquid hexafluoro-1,3-butadiene was refluxed in a receiver in the presence of calcium hydride to further purify the same. The receiver in which the liquefied hexafluoro-1,3-butadiene was put was reverted to room temperature and hexafluoro-1,3-butadiene was collected. Three milliliters (39.26 mmols) of hexafluoro-1,3-butadiene was introduced into the ampoule tube which was connected with the vacuum line and in which cesium fluoride described above had been collected.

The ampoule tube was reverted to normal pressure. After the content of the tube was replaced with nitrogen, 20 ml of purified toluene (which was obtained by refluxing toluene of special grade manufactured by Wako Pure Chemical Industry Co., Ltd. for 2 hours in the presence of calcium hydride and then distilling under reduced pressure) stored in nitrogen atmosphere was added with a syringe to thoroughly dissolve the same. The solution was frozen with liquid nitrogen. The pressure of the ampoule tube was again reduced and the ampoule tube was sealed with a burner.

After sealing the tube, the frozen matter was reconstituted and then reacted on an oil bath at 60 °C for 7 days.

Next, the solution in the ampoule tube was again frozen with liquid nitrogen and the ampoule tube was unsealed. Then, 2 to 3 ml of methanolic hydrochloric acid was added to the reaction solution to terminate the reaction. The reaction solution was poured onto about 200 ml of methanolic hydrochloric acid. The formed precipitates were filtered through a glass filter (1G3), washed with methanolic hydrochloric acid, distilled water and methanol and finally dried under reduced pressure by heating at 80 °C until the weight became constant. The yield was 58.9%. The resulting powder sample was examined with respect to its

infrared absorption spectrum, using IR-400 spectrometer manufactured by Shimadzu Seisakusho Ltd. The results are shown in Fig. 3 (a).

(Preparation of varnish)

In 100.5 parts by weight of dimethylformamide were dissolved 50 parts by weight of 4,4'-bis-(diphenylmethane)maleimide, 50 parts by weight of methacrylate and 0.5 part by weight of peroxide as a polymerization initiator to prepare a 50% solution. To the solution was added 70 parts by weight of the hexafluoro-1,3-butadiene polymer obtained in the above process. The mixture was stirred at a constant temperature to disperse the hexafluoro-1,3-butadiene polymer in the solution. Thus, the varnish was prepared.

(Preparation of prepreg and laminate plate)

After the varnish described above was coated by impregnation on glass cloth (manufactured by Nittobo Co., Ltd., T glass cloth: thickness of 60 $\mu$m), the cloth was dried at 150° C for 10 minutes in a thermostat (air) to obtain the prepreg.

Ten sheets of the resulting prepreg were laminated with each other, which was heated with a press machine under pressure of 30 kgf/cm$^2$ at a temperature of 130° C for 30 minutes. By heating at 200° C under pressure for further an hour, the laminate plate was obtained.

Ten sheets of the resulting prepreg were laminated with each other, on both surfaces of which a copper foil (manufactured by The Furukawa Electric Co., Ltd.; thickness of 70 $\mu$m) was further laminated. The laminate was heated with a press machine under pressure under the same conditions as described above to give the copper foil laminate plate.

With respect to the laminate plates prepared by the foregoing process, their properties were evaluated.

o Specific dielectric constant

Using LF impedance analyzer 4192A (manufactured by Hewlett-Packard), electrostatic capacity of the sample was determined and its specific dielectric constant was calculated, in accordance with JIS-C-6481.

o Peeling strength

Using rheometer NRM-3101D (manufactured by Fudo Industry Co., Ltd.), peeling strength of the copper foil at the vertical direction was measured under conditions of a peeling speed at 50 mm/min., in accordance with JIS-C-6481.

o Temperature at which thermal decomposition is initiated

Using high speed differential thermal balance TGD-7000RH (manufactured by Shinku Riko Co., Ltd.), temperature at which thermal decomposition is initiated was determined. As a sample, 10 mg of the resin component ground into powders was used. Weight loss curve on heating at He flow amount of 100 cm$^2$/min and a temperature elevation rate of 5° C/min. was measured and the temperature showing 5% weight loss was made a temperature at which thermal decomposition was initiated.

o Thermal expansibility

Using thermal mechanical property-measuring device TM-3000 (manufactured by Shinku Riko Co., Ltd.), a sample piece cut out of the laminate plate in a size of 7 mm x 7 mm was measured with respect to thermal expansibility (50 to 220° C) at the thickness direction of the piece. The measurement was performed under a compressed mode of 10 g load at a temperature elevation rate of 2° C/min.

o Flame retardation

Flame retardation was determined by a modification of UL-94 standard.

The results of the measurements are shown in Table 3.

Example 2

Hexafluoro-1,3-butadiene prepolymer powder was synthesized under the same conditions as in Example 1 except for using tetrahydrofuran in place of purified toluene used as the solvent in Example 1. Using the hexafluoro-1,3-butadiene prepolymer powder, a varnish was prepared in the same manner as in Example 1.

In dimethylformamide as a solvent were dissolved 30 parts by weight of 4,4'-bis(maleimidophenoxy-(phenyl)]hexafluoropropane, 30 parts by weight of methyl methacrylate and 40 parts by weight of hexafluoro-1,3-butadiene polymer to prepare a 50% solution. Then, the solution was heated at 120°C for 60 minutes while stirring to perform preliminary reaction. After cooling, 0.5 part by weight of peroxide as a polymerization initiator was added to prepare a varnish.

Using the varnish, the prepreg and laminate plate were prepared in the same manner as in Example 1 and their properties were evaluated. The results are shown in Table 3.

Example 3

Using hexafluoro-1,3-butadiene prepolymer powder synthesized in the same manner as in Example 1, a varnish was prepared in the same manner as in Example 1.

After coating by impregnation the varnish on aromatic polyamide fiber woven cloth Kevlar 49 (manufactured by Du Pont), the prepreg and laminate plate were prepared in the same manner as in Example 1 and their properties were evaluated. The results are shown in Table 3.

Example 4

After coating by impregnation the varnish prepared in Example 1 on aromatic polyamide fiber nonwoven cloth GAU-505-50 (manufactured by Japan Aroma Co., Ltd.), the prepreg and laminate plate were prepared in the same manner as in Example 1 and their properties were evaluated. The results are shown in Table 3.

Example 5

Using hexafluoro-1,3-butadiene prepolymer powder synthesized in the same manner as in Example 1, a varnish was prepared in the same manner as in Example 2.

After coating by impregnation the varnish on Kevlar 49 (same as described above), the prepreg and laminate plate were prepared in the same manner as in Example 1 and their properties were evaluated. The results are shown in Table 3.

Example 6

After coating by impregnation the varnish prepared in Example 5 on GAU-505-50 (same as described above), the prepreg and laminate plate were prepared in the same manner as in Example 1 and their properties were evaluated. The results are shown in Table 3.

Example 7

Hexafluoro-1,3-butadiene prepolymer powder synthesized in the same manner as in Example 1 was subjected to pressure molding under conditions of a pressure of 50 kgf/cm$^2$ at room temperature using a press molding machine to prepare a sheet having a thickness of 100 $\mu$m. The results are shown in Table 3.

Then, 5 sheets thus prepared were alternately laminated with 4 prepregs (prepared under the same conditions as in Example 1) composed of 50 parts by weight of amine-added KELIMIDO K607 (manufactured by Rhone Poulanc Co.) in which the impregnation resin component is bismaleimide, 50 parts by weight of methyl methacrylate, 0.5 part by weight of dicumyl peroxide. The laminate was heated in a press at a temperature of 130°C for 30 minutes under pressure of 30 kgf/cm$^2$ and then cured by heating at 200°C for further an hour to give a laminate plate. Properties of the laminate plate are shown in Table 3.

Example 8

Six sheets of the prepreg prepared in Example 1 were alternately laminated with 5 sheets of the hexafluoro-1,3-butadiene laminate prepared in Example 7 and a laminate plate was prepared under the same conditions as in Example 7. Properties of the laminate plate are shown in Table 3.

Example 9

Six sheets of the prepreg prepared in Example 2 were alternately laminated with 5 sheets of the hexafluoro-1,3-butadiene laminate prepared in Example 7 and a laminate plate was prepared under the same conditions as in Example 7. Properties of the laminate plate are shown in Table 3.

Comparative Example 1

Commercially available polytetrafluoroethylene type laminate plate lined with copper

Comparative Example 2

Commercially available glass polyimide type laminate plate lined with copper

Comparative Example 3

Commercially available glass epoxy resin type laminate plate lined with copper

The results obtained by evaluating properties of the laminate plates in Comparative Examples 1 to 3 are shown in Table 3.

Table 3 Properties of Laminate Plate

| Prperty / Example | Specific dielectric constant (1 MHz) | Copper foil peeling strength (kgf/cm) | Thermal decomposition temperature (°C) | Thermal expansion coefficient 10-5 K-1 | Flame retardation UL-94 |
|---|---|---|---|---|---|
| Exampe 1 | 3.0 | 1.2 | 330 | 8.3 | V-0 |
| Exampe 2 | 3.0 | 1.4 | 321 | 8.1 | V-0 |
| Exampe 3 | 2.9 | 1.5 | 319 | 8.2 | V-0 |
| Exampe 4 | 3.0 | 1.4 | 329 | 8.3 | V-0 |
| Exampe 5 | 2.8 | 1.3 | 327 | 8.5 | V-0 |
| Exampe 6 | 2.8 | 1.6 | 331 | 8.5 | V-0 |
| Exampe 7 | 2.9 | 1.2 | 325 | 8.9 | V-0 |
| Exampe 8 | 2.7 | 1.7 | 342 | 8.1 | V-0 |
| Exampe 9 | 2.7 | 1.5 | 329 | 8.2 | V-0 |
| Comparative Example 1 | 2.7 | 1.3 | 450 | 26.0 | V-0 |
| Comparative Example 2 | 3.8 | 1.2 | 340 | 7.5 | V-0 |
| Comparative Example 3 | 4.7 | 1.4 | 320 | 6.5 | V-0 |

From the results shown in Table 3, it is noted that the laminate plate comprising the resin composition of hexafluoro-1,3-butadiene in accordance with the present invention shows thermal expansibility markedly reduced to 1/3 or less than in the commercially available polytetrafluoroethylene type laminate plate (Comparative Example 1). Furthermore, the specific dielectric constant can be greatly reduced as compared to the laminate plate of glass polyimide type (Comparative Example 2) or as compared to the laminate plate of glass epoxy type (Comparative Example 3).

Next, Examples for preparing multilayer wire substrates using the laminate plates (materials) shown in Examples 1 to 9 are given.

Example 10

Three sheets of the prepreg prepared in Example 1 were lined with a copper foil (70 µm) on both surfaces. In such a state, the laminate was heated in a press at a temperature of 130 °C for 30 minutes under pressure of 30 $kgf/cm^2$. By heating and curing at 200 °C for further an hour, a copper-lined laminate plate was obtained. A circuit was formed on both surfaces of the copper-lined laminate plate. The laminate plate, on both surfaces of which the circuit was formed, was laminated and adhered via one sheet of the prepreg prepared in Example 1 to prepare a pin grid alley substrate for mounting LSI.

Example 11

A microchip carrier substrate for mounting LSI having a six-layer structure was prepared in the same manner as in Example 10. The six-layer structure was composed of two-layered surface layer, two-layered electric source supplying layer and two-layered signal layer.

Example 12

Using the prepreg obtained in Example 1, a module substrate for mounting the microchip carrier substrate obtained in Example 11 was prepared in the same manner as in Example 10. The substrate takes a 36-layered structure composed of two-layered surface layer, 10-layered electric source supplying layer, 16-layered signal layer and 8-layered amplifying layer. This substrate can mount 81 pieces (configuration of 9 x 9) of the microchip carrier substrate obtained in Example 11.

Example 13

Using the prepreg obtained in Example 1, a large area substrate for mounting the module substrate for mounting the microchip carrier substrate obtained in Example 12 was prepared in the same manner as in Example 10. The substrate takes a 54-layered structure composed of two-layered surface layer, 20-layered electric source supplying layer, 24-layered signal layer and 8-layered amplifying layer. This substrate can mount 64 pieces (8 x 8) of the module substrate described above.

Example 14

Using the prepreg obtained in Example 6, a large area substrate for mounting the module substrate for mounting the microchip carrier substrate obtained in Example 12 was prepared in the same manner as in Example 10. The substrate takes a 46-layered structure composed of two-layered surface layer, 16-layered electric source supplying layer, 20-layered signal layer and 8-layered amplifying layer. This substrate can mount 36 pieces (configuration of 6 x 6) of the module substrate described above.

Example 15

Polymerization was performed under the same conditions as in Example 1 except for using tetrahydrofuran in place of purified toluene used as the solvent in Example 1. The yield in the polymerization was 71%.

Example 16

Polymerization was performed under the same conditions as in Example 1 except for using rubidium fluoride and tetrahydrofuran in place of cesium fluoride as the reaction initiator and purified toluene as the solvent in Example 1, respectively. The yield in the polymerization was 6.9%.

Example 17

Polymerization was performed under the same conditions as in Example 1 except for using cesium acetate (manufactured by Wako Pure Chemical Industry Co., Ltd.) and an equimolar mixture of toluene and tetrahydrofuran in place of cesium fluoride as the reaction initiator and purified toluene as the solvent in Example 1, respectively. The yield in the polymerization was 48.8%. Infrared absorption spectrum of the polymer is shown in Fig. 3 (b).

Example 18

Polymerization was performed under the same conditions as in Example 1 except for using n-butyl cesium and tetrahydrofuran in place of cesium fluoride as the reaction initiator and toluene as the solvent in Example 1, respectively. The yield in the polymerization was 43.2%.

Example 19

Polymerization was performed under the same conditions as in Example 1 except for using n-butoxy cesium and tetrahydrofuran in place of cesium fluoride as the reaction initiator and toluene as the solvent in Example 1, respectively. The yield in the polymerization was 80.3%.

Table 4

| Reaction Initiator | Solvent | Reaction temperature (°C) | Reaction Time (H) | Yield (%) |
|---|---|---|---|---|
| Example 1 Cesium fluoride | Toluene | 60 | 7 | 58.9 |
| Example 15 Cesium fluoride | THF | 60 | 7 | 71.0 |
| Example 16 Rubidium fluoride | THF | 60 | 7 | 6.9 |
| Example 17 Cesium acetate | Toluene /Xylene | 60 | 7 | 48.8 |
| Example 18 n-Butyl cesium | THF | 60 | 7 | 43.2 |
| Example 19 t-Butoxy cesium | THF | 60 | 7 | 80.3 |
| Comparative Example 4 n-Butyl lithium | THF | 40 | 7 | 0.5 |
| Comparative Example 5 Ethyl magnesium | THF | 0 | 7 | 0.3 |

The curable material using the hexafluoro-1,3-butadiene polymer of the present invention melts and fluidizes at 100 to 170°C and then three-dimensionally crosslinked to provide the cured molding showing a low dielectric constant, moisture resistance, heat resistance, flame retardation and excellent mechanical properties.

Therefore, multilayer wire circuit substrates having excellent dimensional stability, high density and high

reliability can be provided using the curable material.

That is, the present invention can solve the problems in molding processing and dimensional stability which have been problems in conventional thermoplastic fluorine materials, leading to new applications to the laminate of fluorine materials.

## Claims

1. A hexafluorobutadiene prepolymer represented by general formula:

$$R\text{-}(CF_2 - CF = CF - CF_2)_n\text{-}H$$

wherein n is 4 to 6000, and R is fluorine or a residue of anionic polymerization initiator.

2. A hexafluoro-1,3-butadiene prepolymer as claimed in claim 1, wherein n is 10 to 1000.

3. A process for preparing a hexafluoro-1,3-butadiene prepolymer represented by general formula:

$$R\text{-}(CF_2 - CF = CF - CF_2)_n\text{-}H$$

wherein n is 4 to 6000, and R is fluorine or a residue of anionic polymerization initiator which comprises polymerizing hexafluoro-1,3-butadiene of formula:

$CF_2 - CF = CF - CF_2$

in the presence of an anionic polymerization initiator to form said hexafluoro-1,3-butadiene prepolymer.

4. A process for preparing a hexafluoro-1,3-butadiene prepolymer as claimed in claim 3, wherein n is 10 to 1000.

5. A polymerizable composition comprising a hexafluoro-1,3-butadiene prepolymer represented by general formula:

$$R\text{-}(CF_2 - CF = CF - CF_2)_n\text{-}H$$

wherein n is 4 to 6000, and R is fluorine or a residue of anionic polymerization initiator, and a polymerizable compound.

6. A polymerizable composition as claimed in claim 5, wherein n is 10 to 1000.

7. A polymerizable composition as claimed in claim 5, wherein said polymerizable compound is a vinyl monomer.

8. A curable material comprising a fibrous substrate impregnated with a hexafluoro-1,3-butadiene prepolymer represented by general formula:

$$R\text{-}(CF_2 - CF = CF - CF_2)_n\text{-}H$$

wherein n is 4 to 6000, and R is fluorine or a residue of anionic polymerization initiator.

9. A polymerizable composition as claimed in claim 9, wherein n is 10 to 1000.

10. A laminate obtained by laminating a hexafluoro-1,3-butadiene prepolymer represented by general formula:

$$R \leftarrow\!\!\!\!\!\!\;-\; CF_2 - CF = CF - CF_2 \rightarrow_n H$$

wherein n is 4 to 6000, and R is fluorine or a residue of anionic polymerization initiator, on a curable material comprising a fibrous substrate impregnated with a polymerizable composition, and then curing the laminate.

11. A laminate as claimed in claim 10, wherein a copper foil is adhered to at least one surface of the laminate.

12. A circuit plate as claimed in claim 10, wherein a conductive pattern is provided on at least one surface of the laminate.

13. A print circuit plate comprising a plurality of substrates having a conductive pattern on at least one surface on which a curable material as claimed in claim 10 for adhering said substrates with each other is alternately laminated followed by curing.

FIG. 1

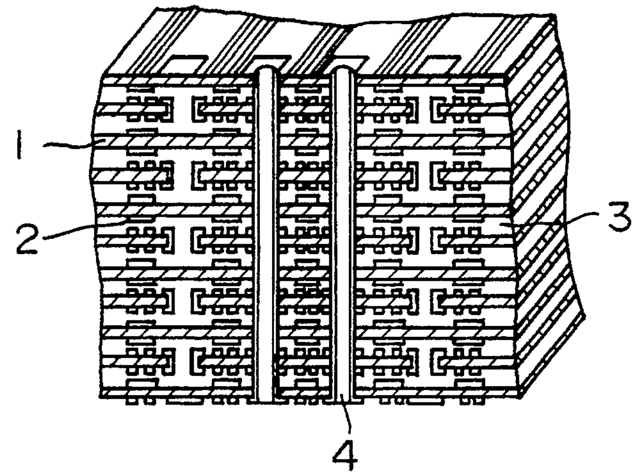


FIG. 2

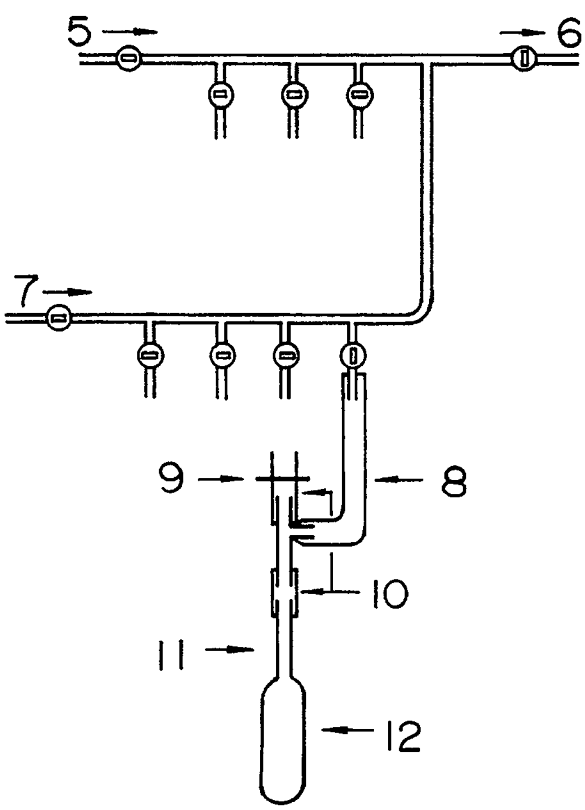

FIG. 3

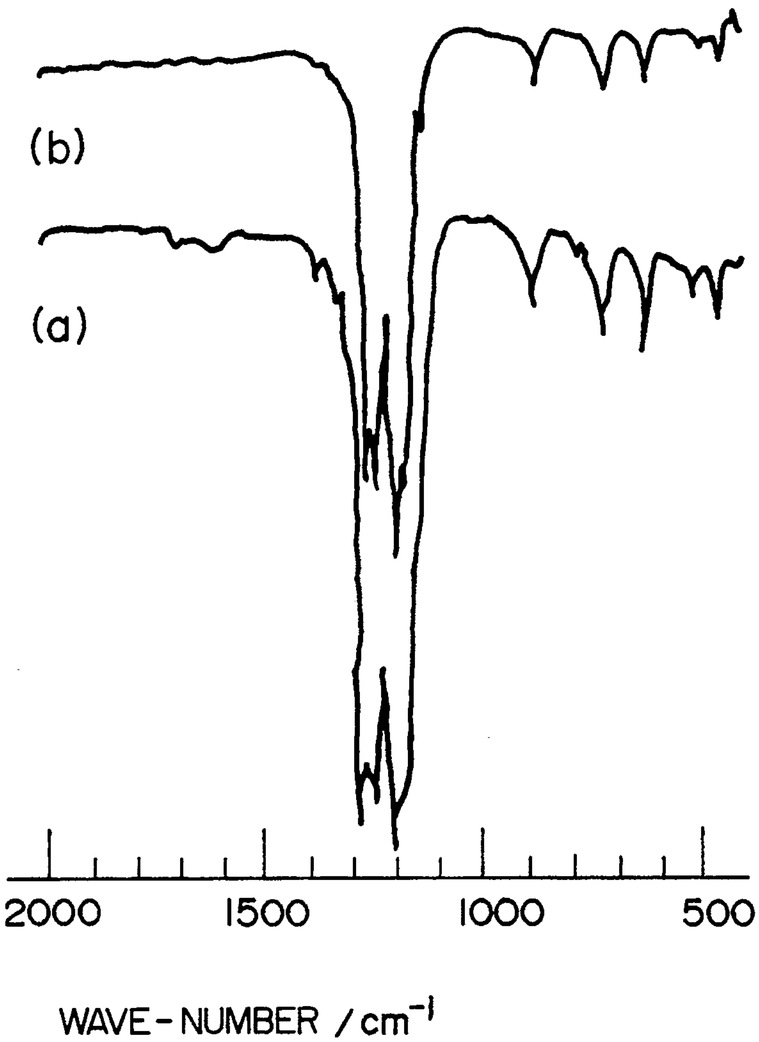

FIG. 4

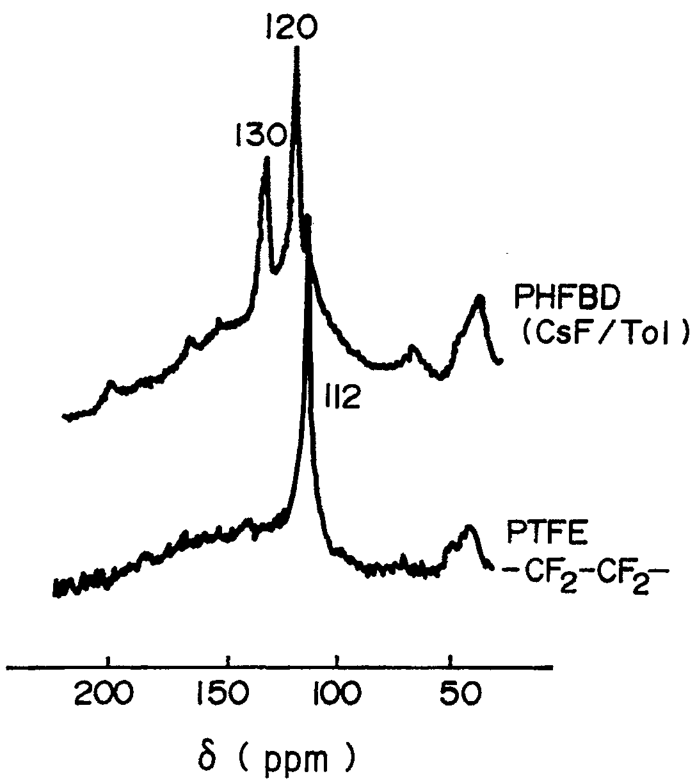

# INTERNATIONAL SEARCH REPORT

International Application No PCT/JP90/01206

**I. CLASSIFICATION OF SUBJECT MATTER** (if several classification symbols apply, indicate all) [6]

According to International Patent Classification (IPC) or to both National Classification and IPC

Int. $Cl^5$ C08F136/16, 299/00, C08J5/24

**II. FIELDS SEARCHED**

Minimum Documentation Searched [7]

| Classification System | Classification Symbols |
|---|---|
| IPC | C08F136/00-136/22, 299/00, C08J5/24 |

Documentation Searched other than Minimum Documentation to the Extent that such Documents are Included in the Fields Searched [8]

| | |
|---|---|
| Jitsuyo Shinan Koho | 1926 - 1990 |
| Kokai Jitsuyo Shinan Koho | 1971 - 1990 |

**III. DOCUMENTS CONSIDERED TO BE RELEVANT** [9]

| Category * | Citation of Document, [11] with indication, where appropriate, of the relevant passages [12] | Relevant to Claim No. [13] |
|---|---|---|
| A | JP, A, 60-79022 (Matsushita Electric Ind. Co., Ltd.), 4 May 1985 (04. 05. 85), (Family: none) | 1 - 13 |
| A | JP, A, 61-145229 (Shin-Kobe Electric Machinery Co., Ltd.), 2 July 1986 (02. 07. 86), (Family: none) | 1 - 13 |
| A | JP, A, 55-36224 (Fujitsu Ltd.), 13 March 1980 (13. 03. 80), (Family: none) | 1 - 13 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| October 9, 1990 (09. 10. 90) | October 29, 1990 (29. 10. 90) |
| **International Searching Authority** | **Signature of Authorized Officer** |
| Japanese Patent Office | |